# EUROPÄISCHE PATENTSCHRIFT

(11) **EP 0 862 209 B1**
(45) Veröffentlichungstag und Bekanntmachung des Hinweises auf die Patenterteilung: **16.12.2009**
(21) Anmeldenummer: 98102845.9
(22) Anmeldetag: 19.02.1998
(51) Int. Cl.: H01L 23/373, H01L 21/48, H05K 3/40

(54) **Verfahren zum Herstellen eines Metall-Keramik-Substrates**
Process for manufacturing a metal-ceramic substrate
Procédé de fabrication d'un substrat métal-céramique

(30) Priorität: 01.03.1997 DE 19708363; 29.11.1997 DE 19753148
(43) Veröffentlichungstag der Anmeldung: 02.09.1998
(73) Patentinhaber: Electrovac AG, 3400 Klosterneuburg (AT)
(72) Erfinder: Dr.-Ing. Jürgen Schulz-Harder, 91207 Lauf (DE)
(74) Vertreter: Graf, Helmut

(56) Entgegenhaltungen:
- EP-A- 0 279 601
- EP-A- 0 523 547
- DE-A- 3 837 618
- DE-A- 4 103 294
- DE-A- 4 319 944
- JP-A- 02 241 205
- US-A- 5 473 137
- PATENT ABSTRACTS OF JAPAN vol. 17, no. 94 (E-1325), 24. Februar 1993 (1993-02-24) & JP 04 287392 A (TAIYO YUDEN CO), 12. Oktober 1992 (1992-10-12)
- PATENT ABSTRACTS OF JAPAN vol. 1996, no. 7, 31. Juli 1996 (1996-07-31) & JP 08 083864 A (MEIDENSHA CORP), 26. März 1996 (1996-03-26)

## Beschreibung

Die Erfindung bezieht sich auf ein Verfahren gemäß Oberbegriff Patentanspruch 1.

Bekannt ist, die zum Herstellen von Leiterbahnen, Anschlüssen usw. benötigte Metallisierung auf einer Keramik mit Hilfe des sogenannten "DCB-Verfahrens" (Direct-Copper-Bond-Technology) herzustellen (US-A-5 473 137), und zwar unter Verwendung von die Metallisierung bildenden, an ihren Oberflächen oxidierten Kupferfolien. Die Kupferoxidschicht dieser Folien bildet ein Eutektikum mit einer Schmelztemperatur unter der Schmelztemperatur des Kupfers, so daß durch Auflegen der Folien auf die Keramik und durch Erhitzen sämtlicher Schichten diese miteinander verbunden werden können, und zwar durch Aufschmelzen des Kupfers im wesentlichen nur im Bereich der Oxidschicht. Das DCB-Verfahren ist eine dem Fachmann bekannte Technik, die z.B. folgende Verfahrensschritte aufweist:
- Oxidieren eines Kupferbleches derart, daß sich eine gleichmäßige Kupferoxidschicht ergibt;
- auflegen des Kupferbleches auf die Keramikschicht;
- erhitzen des Verbundes auf beispielsweise ca. 1071°C;
- abkühlen auf Raumtemperatur.

Bekannt ist speziell auch ein Halbleiterleistungsschaltkreis (Patent Abstracts of Japan vol. 1996, no. 7, 31. Juli 1996, JP08083864A), der als Leiterplatte für einen Halbleiter-Leistungs-Chip ein Keramik-Metall-Substrat aufweist, und zwar bestehend aus einer Keramikschicht, auf der beidseitig mit Hilfe der DCB-Technik jeweils eine von einer Kupferfolie gebildete Metallisierung aufgebracht ist. Die Metallisierung an einer Oberflächenseite der Keramikschicht ist zur Bildung von Leiterbahnen strukturiert. Die Metallisierung auf der anderen Oberflächenseite der Keramikschicht dient zum thermischen Anschluß des Keramik-Metall-Substrates an ein weiteres Bauteil, offenbar an einem Kühler.

Bekannt ist weiterhin ein Verfahren zum Herstellen eines Substrates (JP 02241205 A), welches aus einer isolierenden Schicht und aus Metallisierungen auf beiden Oberflächenseiten dieser Schicht besteht, wobei die Metallisierungen auf beiden Oberflächenseiten der isolierenden Schicht unter Verwendung der Dickfilmtechnik erzeugt werden.

Aufgabe der Erfindung ist es, ein Herstellungsverfahren aufzuzeigen, mit welchem es möglich ist, Metall-Keramik-Substrate für elektrische Leistungsschaltkreise preiswert und auch mit optimalen thermischen Eigenschaften herzustellen. Zur Lösung dieser Aufgabe ist ein Verfahren entsprechend dem Patentanspruch 1 ausgebildet.

Bei den mit dem erfindungsgemäßen Verfahren hergestellten Substraten bildet die unter Verwendung der Dickfilm- oder Dünnfilmtechnik hergestellte "zweite" Metallisierung bevorzugt eine Zwischenschicht, die insbesondere einen verbesserten thermischen und/oder elektrischen Übergang zwischen der Keramikschicht und einer metallischen Grundplatte bewirkt, auf der das Substrat angeordnet ist und die ihrerseits mit einem Kühlkörper oder einer Wärmesenke verbunden ist oder aber Bestandteil dieser Wärmesenke ist. Die Verbindung zwischen dem Substrat und der Grundplatte ist beispielsweise eine Lötverbindung. Grundsätzlich ist es auch möglich, diese Verbindung durch Verspannen herzustellen. Strukturiert ist bei der Erfindung die durch DCB-Technik hergestellte erste Metallisierung, die die Leiterbahnkontaktflächen usw. für die Bauelemente bildet.

Weiterbildungen der Erfindung sind Gegenstand der Unteransprüche. Die Erfindung wird im Folgenden anhand der Figuren an Ausführungsbeispielen näher erläutert. Es zeigen:
- Fig. 1: in vereinfachter Darstellung und im Schnitt ein unter Verwendung der Erfindung hergestelltes Substrat bzw. ein mit diesem hergestellter elektrischer Schaltkreis;
- Fig. 2: in vereinfachter Darstellung und in Draufsicht ein Mehrfach-Substrat mit einer Vielzahl von an Sollbruchlinien aneinander anschließenden Einzelsubstraten;
- Fig. 3: einen Schnitt entsprechend der Linie I - I der Figur 2;
- Fig. 4: in einer Darstellung ähnlich Figur 1 ein weiteres, nach der Erfindung hergestelltes Bauteil bzw. Substrat;
- Fig. 5: in vereinfachter Schnittdarstellung ein weiteres, unter Verwendung der Erfindung hergestelltes Substrat;
- Fig. 6 und 7: in vereinfachter Darstellung und im Schnitt weitere mögliche Ausführungsformen des erfindungsgemäßen Substrats.

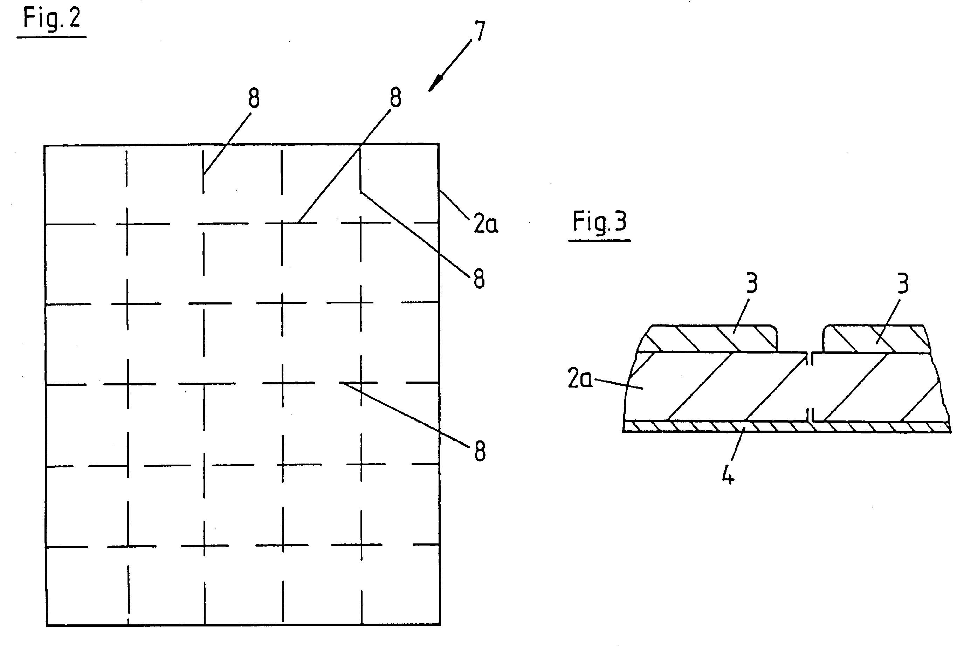

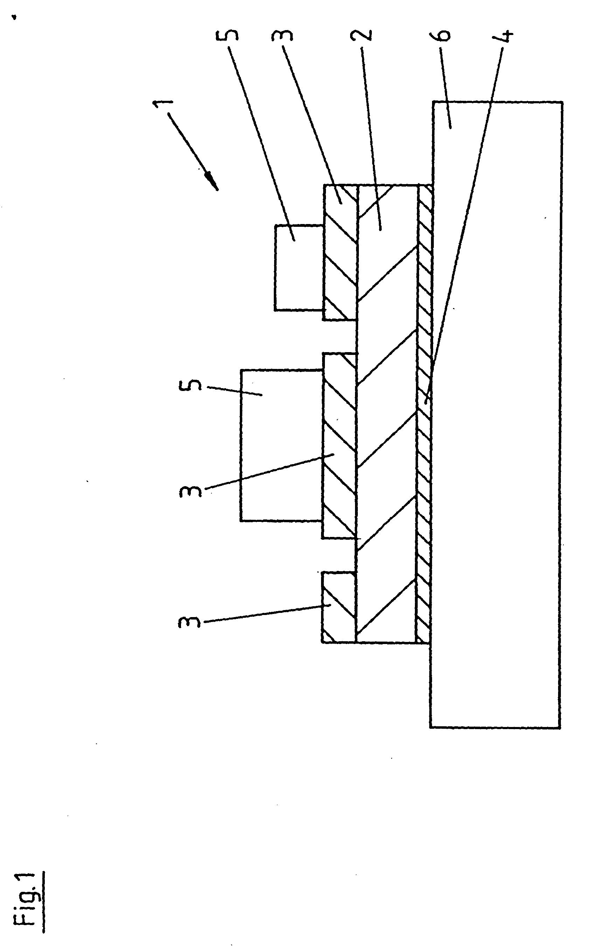

In den Figuren 1 - 3 ist 1 ein Metall-Keramik-Einzelsubstrat bestehend aus einer Keramikschicht 2 (beispielsweise Aluminiumnitrid-Keramik), aus einer oberen Metallisierung 3, die flächig auf der Oberseite der Keramikschicht 2 vorgesehen und flächig mit dieser verbunden ist, sowie aus einer unteren Metallisierung 4, die ebenfalls flächig mit der Unterseite der Keramikschicht 2 verbunden ist. Die Metallisierung 3 ist zur Bildung von Leiterbahnen und Kontaktflächen für elektronische Bauelemente 5, von denen wenigstens eines ein Leistungsbauelement ist, strukturiert. An die untere Metallisierung 4 schließt sich eine u.a. auch als Kühlkörper dienende oder mit einem Kühlkörper verbundene Grundplatte 6 aus Metall an. Die Metallisierungen 3 und 4 bestehen aus Kupfer. Ebenso ist die Grundplatte 6 aus Kupfer gefertigt. Über die Metallisierung 4 ist das Einzelsubstrat 1 entweder mit der Grundplatte 6 verspannt, und zwar durch ein nicht dargestelltes mechanisches Feder- oder Verspannelement, oder aber mit der Grundplatte 6 verlötet.

Die Herstellung des Substrates 1 erfolgt in mehreren Verfahrensschritten, nämlich zunächst wird auf einer Oberflächenseite der Keramikschicht, die eine Dicke zwischen 0,2 und 2 mm aufweist mit Hilfe des DCB-Prozesses unter Verwendung einer Kupferfolie mit einer Dicke von 0,2 bis 6 mm die obere Metallisierung aufgebracht. In einem weiteren Verfahrensschritt kann dann eine Oberflächenveredelung, beispielsweise eine Vernikelung der freiliegenden Flächen der Metallisierung 3, ggfs. auch der Metallisierung 4 erfolgen.

Bei dem vorstehend beschriebenen Verfahren wird die Dicke der durch Dickfilmtechnik hergestellten Metallisierung 4 bewußt kleiner gehalten als die Dicke der Metallisierung 3, da die Metallisierung 4 lediglich dazu dient, einen möglichst gleichmäßigen, d.h. insbesondere auch Unebenheiten in der Keramikoberfläche ausgleichenden thermischen und/oder elektrischen Übergang zwischen dem Einzelsubstrat 1 und der Grundplatte 6 herzustellen.

Nach dem Säubern durch Mikroätzung sowie ggfs. nach der Oberflächenveredelung erfolgt dann die Bestückung mit dem Bauelement 5.

Die Einzelsubstrate 1 werden bevorzugt im Mehrfachnutzen 7, d.h. in Form eines Mehrfachsubstrates hergestellt, welches eine großflächige Keramikschicht oder -platte 2a aufweist, die mit einer Vielzahl von Sollbruchlinien 8 versehen ist. An diesen Sollbruchlinien kann dann das Mehrfachsubstrat 7 nach der Fertigstellung und Bestückung in Einzelsubstrate 1 durch Brechen zertrennt werden.

An der einen Oberflächenseite der Keramikschicht 2a erfolgt dann nach dem Aufbringen einer die Metallisierungen 3 bildenden Kupferfolie mit Hilfe des DCB-Prozesses und nach einer entsprechenden Strukturierung dieser Kupferfolie zur Bildung der einzelnen, voneinander unabhängigen "Lay-outs" für die Einzelsubstrate an der Unterseite der Keramikschicht 2a ein großflächiges Aufbringen der Paste für die Metallisierung 4 und ein anschließendes Trocknen und Brennen dieser Paste.

Die Sollbruchlinien sind beispielsweise durch Kerben oder Ritzungen gebildet, die bei der dargestellten Ausführungsform sich jeweils an der Ober- und Unterseite der Keramikschicht 2a gegenüberliegen und beispielsweise auf mechanischem Wege oder mittels Laser eingebracht sind. Nach dem Fertigstellen des Mehrfachsubstrates 7, d.h. nach dem Abschluß der oben genannten Verfahrensschritte und vorzugsweise auch nach dem Bestücken der Einzelsubstrate 1 werden diese dann durch Brechen der Keramikschicht 2a entlang der Sollbruchlinien voneinander getrennt. Die Metallisierung 4 ist sehr dünn und außerdem relativ spröde, so daß ein Brechen möglich ist, obwohl die Sollbruchlinien 8 von der unteren Metallisierung 4 überbrückt sind.

Das großflächige Aufbringen der Metallisierung 4 bzw. das großflächige Aufbringen der diese Metallisierung bildenden Paste, welches beispielsweise wiederum mit einer Siebdrucktechnik erfolgt, hat den Vorteil, daß unabhängig von der Größe und Ausbildung der einzelnen Substrate 1, insbesondere auch unabhängig vom Verlauf und der Anzahl der Sollbruchlinien 8 für die Herstellung der Metallisierungen 4 ein Standardsieb verwendet werden kann.

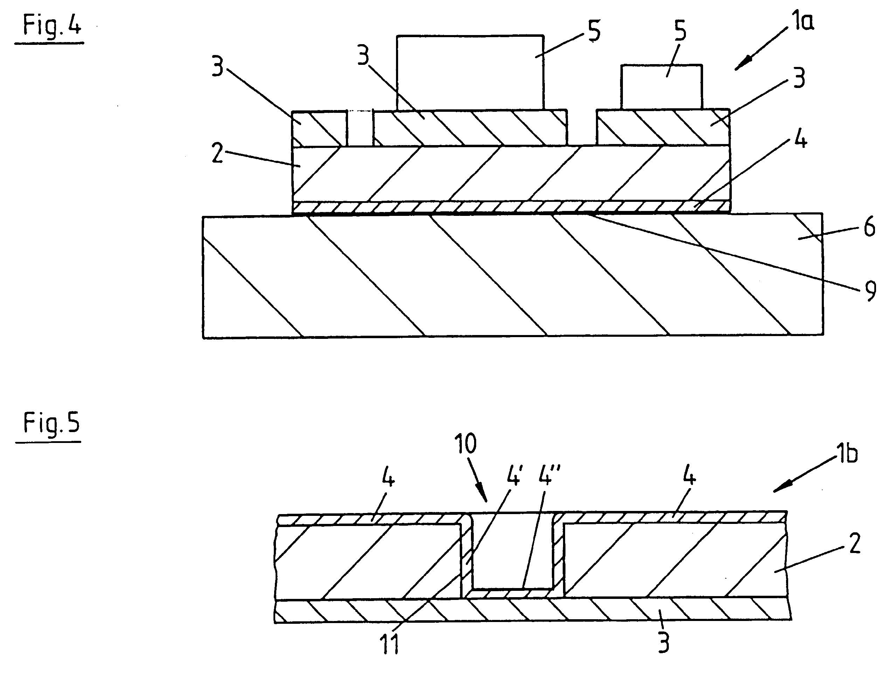

Die Figur 4 zeigt in einer Darstellung ähnlich Figur 1 eine weitere mögliche Ausführungsform eines Schaltkreises mit einem Einzelsubstrat 1a. Dieses Einzelsubstrat 1a besteht wiederum aus der Keramikschicht 2, den beiden Metallisierungen 3 und 4, wobei auf der der Keramikschicht 2 abgewandten Seite der Metallisierung 4 eine dünne Oberflächenschicht 9 vorgesehen ist.

Hergestellt ist das Einzelsubstrat 1a in einem Verfahren mit folgenden Schritten:
Auf eine oben liegende Seite der Keramikschicht 2, die beispielsweise eine Dicke von 0,2 bis 2 mm aufweist, wird eine Paste, die Molybdän (Mo), Mangan (Mn) oder Wolfram enthält als dünne Schicht oder als Dünnfilm mit einer Dicke von 0,005 bis 0,01 mm aufgebracht. Die Schicht wird dann getrocknet und in einer reduzierenden, d.h. wasserstoffhaltigen Atmosphäre bei einer Temperatur zwischen etwa 1200 bis 1300°C eingebrannt.

In einem anschließenden Verfahrensschritt erfolgt dann nach einem evtl. Reinigen der Keramikschicht 2 das Aufbringen einer die Metallisierung 3 bildenden Kupferfolie mit einer Dicke von 0,1 bis 0,6 mm mit Hilfe des DCB-Prozesses.

In einem anschließenden Verfahrensschritt erfolgt das Strukturieren der Kupferschicht 3 insbesondere zur Bildung des " lay-outs" für die Bauelemente 5 unter Verwendung üblicher Maskierungs- und Ätztechniken. Die erzeugte Metallisierung 4 wird bei dieser Strukturierung nicht beeinträchtigt.

In einem weiteren Verfahrensschritt erfolgt dann ein Reinigen oder Säubern der Oberflächen durch Mikroätzung.

In einem weiteren Verfahrensschritt wird zumindest die Metallisierung 4 zur Bildung der Zwischenschicht 9 vernickelt. Grundsätzlich kann auch eine Vernickelung der strukturierten Metallisierung 3 erfolgen. Durch die dünne Zwischenschicht 9 ist das Einzelsubstrat 1a dann auch an seiner Unterseite lötbar.

Die Figur 4 zeigt in vereinfachter Darstellung ein Einzelsubstrat 1b, welches ähnlich dem Substrat 1 der Figur 1 ausgebildet ist, d.h. aus der Keramikschicht 2 und den beiden Metallisierungen 3 und 4 besteht. Die Keramikschicht 2 weist bei dem Substrat 1b allerdings eine Durchkontaktierung 10 auf, die durch eine Öffnung 11 in der Keramikschicht 2 hergestellt ist, in die ebenfalls die zur Herstellung der Metallisierung 4 verwendete Paste eingebracht ist, und zwar derart, daß diese Paste bzw. die von der Paste gebildete Metallisierung sich bei 4' am Rand der Öffnung und bei 4" am Boden der Öffnung 11 fortsetzt und mit der die Öffnung überdeckenden Metallisierung 3 eine elektrische Verbindung herstellt.

Die Herstellung des Substrates 1b erfolgt grundsätzlich mit den gleichen Verfahrensschritten und unter Verwendung der gleichen Materialien wie die Herstellung des Substrates 1, d.h. in einem ersten Verfahrensschritt wird auf die Keramikschicht 2 mit der Dicke im Bereich von etwa 0,2 bis 2 mm mit Hilfe des DCB-Prozesses die die Metallisierung 3 bildende Kupferfolie mit einer Dicke von etwa 0,2 bis 0,6 mm aufgebracht, und zwar derart, daß diese Kupferfolie bzw. Metallisierung 3 auch die Öffnung 11 an einer Oberflächenseite der Keramikschicht 2 überdeckt. Anschließend erfolgt wiederum die Strukturierung der Metallisierung 3 zur Bildung des Lay-outs für die Bauelemente 5. In einem weiteren Verfahrensschritt wird dann auf die mit der Metallisierung 3 nach unten orientierte Keramikschicht 2, die die Metallisierung aus Kupfer bildende Paste aufgebracht, und zwar derart, daß diese Paste auch den Randbereich 4' und Bodenbereich 4'' bildet. Das beim Auftragen der Paste verwendete Druck-Sieb ist hierfür beispielsweise entsprechend ausgebildet, so daß die Paste auch in die Öffnung 11 in der gewünschten Weise eingedrückt wird. Grundsätzlich besteht aber auch die Möglichkeit, die Paste in die Öffnung 11 unter Verwendung eines Dispensers einzubringen.

Nach dem Trocknen und Brennen der Paste stellt sich in überraschender Weise nicht nur eine Verbindung zwischen den Keramikflächen und der von der Paste gebildeten Metallisierung, sondern auch eine Verbindung zwischen den beiden Metallisierungen 3 und 4 am Boden der Öffnung 11 her.

An das Brennen der die Metallisierung 4 bildenden Paste schließen sich dann beispielsweise die vorstehend im Zusammenhang mit der Figur 1 beschriebenen Verfahrensschritte an.

Als Paste eignet sich beispielsweise wiederum das von der Firma Dupont unter der Bezeichnung "Serie 6003-Low fire copper" angebotene Produkt.

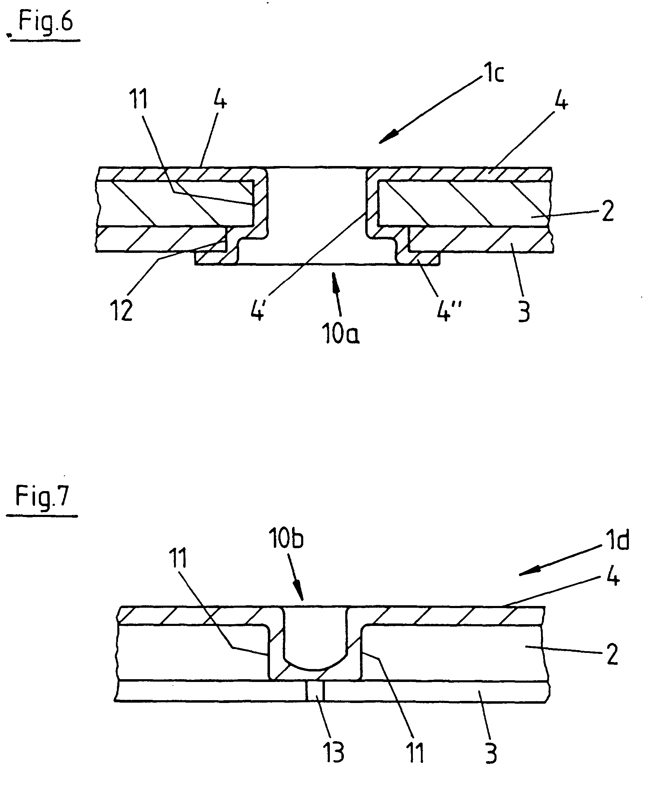

Die Figur 6 zeigt in vereinfachter Schnittdarstellung ein Substrat 1c, bei dem die Durchkontaktierung 10a dadurch erzeugt ist, daß die Metallisierung 3 im Bereich der Durchkontaktierung 10a eine Öffnung 12 aufweist, die deckungsgleich mit der in der Keramikschicht 2 für die Durchkontaktierung 10a vorgesehene Öffnung 11 ist. Das Aufbringen der Metallisierung 4 bildenden Paste erfolgt dann so, daß diese Paste nicht nur den Randbereich 4' der Öffnung 11 abdeckt, sondern auch bis an die mit der Metallisierung 3 versehene Seite der Keramikschicht 2 reicht, dort den die Öffnung 11 umschließenden Rand der Keramikschicht 2 und auch den die Öffnung 12 umschließenden Bereich der Metallisierung 3 abdeckt.

Im Anschluß daran erfolgt dann wiederum das Trocknen und Brennen der Paste, so daß sich in überraschender Weise eine Verbindung nicht nur zwischen den Keramikflächen und der von der Paste gebildeten Metallisierung 4, sondern auch die Verbindung zwischen den beiden Metallisierungen 3 und 4 in dem die Öffnung 12 umgebenden Bereich eintritt, und zwar sowohl an dem die Öffnung 12 umschließenden Rand der Metallisierung 3, als auch an dem der Keramikschicht 2 abgewandten Oberseite bzw. an dem dortigen Randbereich der Metallisierung 3.

Die Figur 7 zeigt ein Substrat 1d, welches sich von dem Substrat 1b im wesentlichen nur dadurch unterscheidet, daß in der Metallisierung 3 im Bereich der Öffnung 11 wenigstens ein Durchlaß 13 vorgesehen ist, welcher allerdings einen im Vergleich zur Öffnung 11 sehr viel kleineren Durchmesser aufweist und lediglich zur Entlüftung dient, so daß die die Metallisierung bildende Paste beim Herstellen der Durchkontaktierung 10b, die der Durchkontaktierung 10 entspricht, besser in die Öffnung 11 einfließen kann, da evtl. von der Paste eingeschlossene Luft nach unten durch die Entlüftungsöffnung 13 entweichen kann.

Wie in der Figur 7 dargestellt ist, wird die Entlüftungsöffnung 13 von der die Metallisierung 4 bzw. den Abschnitt 4'' bildenden Paste überdeckt. Der Durchmesser der Entlüftungsöffnung 13 ist unter Berücksichtigung der Viskosität der verwendeten Paste so gewählt, daß diese nicht durch die Öffnung 13 abfließt, sondern auch im noch zähflüssigen Zustand die Entlüftungsöffnung 13 überbrückt.

Die Erfindung wurde voranstehend an Beispielen beschrieben.

### Bezugszeichenliste

- 1, 1a, 1b: Substrat
- 1c, 1d: Substrat
- 2, 2a: Keramikschicht
- 3, 4: Metallisierung
- 4': Randmetallisierung
- 4": Bodenmetallisierung
- 5: Bauelement
- 6: Grundplatte
- 7: Mehrfachnutzen
- 8: Sollbruchlinie
- 9: Zwischenschicht
- 10, 10a, 10b: Durchkontaktierung
- 11: Öffnung
- 12, 13: Öffnung

## Patentansprüche

1. Verfahren zum Herstellen eines Keramik-Metall-Substrates für elektrische Schaltkreise, bei dem auf eine Keramikschicht (2) beidseitig Metallisierungen (3, 4) aufgebracht werden, und zwar auf eine Oberflächenseite eine erste Metallisierung (3), die in Form einer Kupferfolie unter Verwendung des DCB-Verfahrens aufgebrach wird und zur Bildung von Leiterbahnen und Kontaktflächen strukturierte wird, **dadurch gekennzeichnet, daß** zur Bildung einer metallischen Zwischenschicht, über die das Keramik-Metall-Substrat (1, 1a, 1b) thermisch und/oder elektrisch an ein weiteres Bauteil anschließbar ist, auf der anderen Oberflächenseite der Keramikschicht (2) eine zweite Metallisierung (4) mit einer im Vergleich zur ersten Metallisierung sehr viel kleineren Dicke unter Verwendung einer das Metall dieser zweiten Metallisierung enthaltenden Paste in Dickfilm- oder Dünnfilmtechnik aufgebracht wird.

2. Verfahren nach Anspruch 1, **dadurch gekennzeichnet, daß** auf eine Seite der Keramikschicht (2) die erste Metallisierung und auf die andere Seite der Keramikschicht (2) die zweite Metallisierung aufgebracht werden.

3. Verfahren nach Anspruch 1 oder 2, **dadurch gekennzeichnet, daß** zur Herstellung des Substrates (1 b) mit wenigstens einer Durchkontaktierung (10) die Keramikschicht (2) eine Öffnung (11) aufweist, und daß beim Aufbringen der die zweite Metallisierung (4) bildenden Paste diese auch in die Öffnung und auf eine in der Öffnung freiliegende Fläche der ersten Metallisierung (3) aufgebracht wird. (Fig. 6)

4. Verfahren nach einem der vorhergehenden Ansprüche, **gekennzeichnet,**
**durch** die Verwendung einer Keramikschicht (2) mit einer Dicke im Bereich zwischen 0,2 bis 2 mm und/oder
**durch** die Verwendung einer Kupferfolie mit einer Dicke im Bereich zwischen 0,1 bis 0,6 mm.

5. Verfahren nach einem der vorhergehenden Ansprüche, **dadurch gekennzeichnet, daß** zur Bildung der zweiten Metallisierung aus Kupfer eine Kupfer enthaltende Paste mit einer Dicke von 0,01 bis 0,1 mm aufgebracht wird.

6. Verfahren nach einem der vorhergehenden Ansprüche, **dadurch gekennzeichnet, daß** zunächst auf eine Oberflächenseite der Keramikschicht (2) unter Verwendung der Kupferfolie und des DCB-Verfahrens die erste Metallisierung (3) erzeugt wird, daß in einem weiteren Verfahrensschritt eine Strukturierung der die erste Metallisierung bildenden Kupferfolie erfolgt, und daß in einem nachfolgenden Verfahrensschritt das Aufbringen der die zweite Metallisierung aus Kupfer bildenden Paste, das Trocknen der aufgebrachten Paste und das anschließende Brennen unter Stickstoffatmosphäre bei einer im Vergleich zum DCB-Prozeß niedrigeren Temperatur erfolgen.

7. Verfahren nach einem der vorhergehenden Ansprüche, **dadurch gekennzeichnet, daß** nach dem Herstellen der zweiten Metallisierung ein Finishing zumindest durch Säuberung der Oberflächen und/oder durch Entfernen von Oxiden oder Pastenresten durch Fein- oder Mikroätzen erfolgt.

8. Verfahren nach einem der vorhergehenden Ansprüche, **dadurch gekennzeichnet, daß** in einem weiteren Verfahrensschritt eine Vernickelung der ersten und/oder zweiten Metallisierung (3, 4) an freiliegenden Flächen erfolgt.

9. Verfahren nach einem der vorhergehenden Ansprüche, **dadurch gekennzeichnet, daß** zur Bildung der zweiten Metallisierung auf die Keramikschicht (2) als dünner Film oder dünne Schicht mit einer Dicke von 0,05 bis 0,01 mm eine Molybdän (Mo), Mangan (Mn) oder Wolfram enthaltende Paste aufgebracht wird.

10. Verfahren nach einem der vorhergehenden Ansprüche, **dadurch gekennzeichnet, daß** auf die Keramikschicht (2) zunächst als dünner Film oder dünne Schicht die Molybdän (Mo), Mangan (Mn) oder Wolfram enthaltende Paste aufgebracht, anschließend getrocknet und bei einer Temperatur zwischen 1200 bis 1300°C gebrannt wird, daß in einem anschließenden Verfahrensschritt mit Hilfe der DCB-Technik eine die erste Metallisierung bildende Kupferfolie auf die andere Oberflächenseite der Keramikschicht aufgebracht wird, daß die erste Metallisierung anschließend strukturiert wird, und daß zumindest in die zweite Metallisierung in einem weiteren Verfahrensschritt vernickelt wird,
wobei beispielsweise nach dem Strukturieren der die erste Metallschicht bildenden Kupferfolie ein Finishing, zumindest ein Fein- oder Mikroätzen erfolgt.

11. Verfahren nach einem der vorhergehenden Ansprüche, **dadurch gekennzeichnet, daß** das Substrat (1, 1a, 1b) zusammen mit einer Vielzahl weiterer Substrate in einem Mehrfachnutzen (7) unter Verwendung einer großformatigen Keramikplatte (2a) hergestellt wird, und daß die mit Sollbruchlinien (8) versehene Keramikplatte an einer Oberflächenseite großflächig mit der zweiten Metallisierung (4) versehen wird bzw. auf diese eine Oberflächenseite der Keramikplatte (2a) großflächig und die Sollbruchlinien (8) überdeckend die die zweite Metallisierung bildende Paste aufgebracht wird.

12. Verfahren nach einem der vorhergehenden Ansprüche, **dadurch gekennzeichnet, daß** das Substrat (1, 1a, 1b) an der zweiten Metallisierung (4) mit einer Grundplatte (6) aus Metall verbunden wird, beispielsweise durch Lötung oder Verspannen.

13. Verfahren nach einem der vorhergehenden Ansprüche, **dadurch gekennzeichnet, daß** zur Herstellung der Durchkontaktierung die die zweite Metallisierung (4) bildende Paste durch eine Öffnung (11) in der Keramikschicht (2) sowie durch eine Öffnung in der die erste Metallisierung (3) bildenden Kupferfolie hindurch derart aufgebracht wird, daß die Paste auch die die erste Metallisierung (3) bildende Kupferfolie in einem die Öffnung (11, 12) für die Durchkontaktierung (10a) benachbarten Bereich abdeckt.

14. Verfahren nach einem der vorhergehenden Ansprüche, **dadurch gekennzeichnet, daß** bei der Herstellung der wenigstens einen Durchkontaktierung die die erste Metallisierung (3) bildende Kupferfolie oder die erste Metallisierung (3) im Bereich der Öffnung (11) in der Keramikschicht (2) mit wenigstens einer Entlüftungsöffnung (13) versehen ist.

## Claims

1. Method for manufacturing a ceramic-metal substrate for electrical circuits wherein metal platings (3, 4) are applied to both sides of a ceramic layer (2), namely on one surface side a first metal plating (3) which is applied in the form of a copper foil by using the DCB method and is structured to form conductor paths and contact faces, **characterised in that** in order to form a metal interface layer via which the ceramic-metal substrate (1, 1a, 1b) can be attached thermally and/or electrically to a further component part, on the other surface side of the ceramic layer (2) a second metal plating (4) is applied which has a very much smaller thickness compared with the first metal plating by using a paste containing the metal of this second metal plating through thick film or thin film technology.

2. Method according to claim 1 **characterised in that** the first metal plating is applied to one side of the ceramic layer (2) and the second metal plating is applied to the other side of the ceramic layer (2).

3. Method according to claim 1 or 2 **characterised in that** in order to produce the substrate (1b) with at least one through-plating (10) the ceramic layer (2) has an opening (11), and that when applying the paste which forms this second metal plating (4) this paste is also applied into the opening and onto a surface area of the first metal plating (3) which is exposed in the opening.

4. Method according to one of the preceding claims **characterised by** the use of a ceramic layer (2) having a thickness in the range of between 0.2 and 2 mm and/or through the use of a copper foil having a thickness in the range of between 0.1 and 0.6 mm.

5. Method according to one of the preceding claims **characterised in that** to form the second metal plating of copper a copper-containing paste is applied with a thickness of 0.01 to 0.1 mm.

6. Method according to one of the preceding claims **characterised in that** initially the first metal plating (3) is produced on one surface side of the ceramic layer (2) by using the copper foil and the DCB method, that in a further method step the copper foil forming the first metal plating is structured, and that in a following method step the paste forming the second metal plating of copper is applied, the applied paste is dried and then fired in a nitrogen atmosphere at a lower temperature compared with that in the DCB process.

7. Method according to one of the preceding claims **characterised in that** after producing the second metal plating finishing is carried out at least by cleaning the surfaces and/or by removing oxides or paste residues through fine or micro etching.

8. Method according to one of the preceding claims **characterised in that** in a further method step the first and/or second metal platings (3, 4) are nickel-plated on their exposed surface areas.

9. Method according to one of the preceding claims **characterised in that** in order to form the second metal plating on the ceramic layer (2) a molybdenum (Mo)-, manganese (Mn)- or tungsten-containing paste is applied as a thin film or thin coating.

10. Method according to one of the preceding claims **characterised in that** the molybdenum (Mo)-, manganese (Mn)- or tungsten-containing paste is first applied as a thin film or thin coating to the ceramic layer (2), then dried and then fired at a temperature between 1200° and 1300°C, that in a following method step using DCB technology a copper foil forming the first metal plating is applied to the other surface side of the ceramic layer, that the first metal plating is then structured, and that at least the second metal plating is nickel-plated in a further method step, wherein by way of example after the structuring of the copper foil forming the first metal layer, finishing, at least by fine or micro etching, is carried out.

11. Method according to one of the preceding claims **characterised in that** the substrate (1, 1a, 1b) is manufactured together with a number of further substrates in a multi-printed panel (7) by using one large-format ceramic plate (2a), and that the ceramic plate which is provided with ideal break lines (8) is provided over a large surface, area on one surface side with the second metal plating (4) or the paste forming the second metal plating is applied over a large surface area on this one surface side of the ceramic plate (2a) covering the ideal break lines (8).

12. Method according to one of the preceding claims **characterised in that** the substrate (1, 1a, 1b) on the second metal plating (4) is connected to a base plate (6) of metal, by way of example through soldering or bracing.

13. Method according to one of the preceding claims **characterised in that** in order to produce the through-plating the paste forming the second metal plating (4) is applied through an opening (11) in the ceramic layer (2) as well as through an opening in the copper foil forming the first metal plating (3) so that the paste also covers the copper foil forming the first metal plating (3) in an area adjoining the opening (11, 12) for the through-plating (10a).

14. Method according to one of the preceding claims **characterised in that** when producing the at least one through-plating the copper foil forming the first metal plating (3) or the first metal plating (3) itself is provided in the region of the opening (11) in the ceramic layer (2) with at least one vent hole (13).

## Revendications

1. Procédé pour la fabrication d'un substrat céramique-métal destiné à des circuits électriques, dans lequel des métallisations (3, 4) sont appliquées sur les deux faces d'une couche de céramique (2), à savoir, sur une face, une première métallisation (3) qui est appliquée sous la forme d'une feuille de cuivre en recourant au procédé DCB et est structurée pour la formation de bandes de conducteurs et de surfaces de contact, **caractérisé en ce que** pour la formation d'une couche intermédiaire métallique via laquelle le substrat céramique-métal (1, 1a, 1b) est connectable thermiquement et/ou électriquement à un autre composant, sur l'autre face de la couche de céramique (2) une deuxième métallisation (4) avec une épaisseur beaucoup plus réduite par rapport à la première métallisation est appliquée en utilisant une pâte contenant le métal de cette deuxième métallisation selon la technique du film épais ou du film mince.

2. Procédé selon la revendication 1, **caractérisé en ce que**, sur une face de la couche de céramique (2), la première métallisation et, sur l'autre face de la couche de céramique (2), la deuxième métallisation sont appliquées.

3. Procédé selon la revendication 1 ou 2, **caractérisé en ce que** pour la fabrication du substrat (1b) avec au moins un contact total (10) la couche de céramique (2) présente une ouverture (11) et que lors de l'application de la pâte formant la deuxième métallisation (4), celle-ci est également appliquée dans l'ouverture et sur une surface libre dans l'ouverture de la première métallisation (3).

4. Procédé selon l'une des revendications qui précèdent, **caractérisé par** l'utilisation d'une couche de céramique (2) d'une épaisseur dans le domaine compris entre 0,2 et 2 mm et/ou par l'utilisation d'une feuille de cuivre d'une épaisseur dans le domaine compris entre 0,1 et 0,6 mm.

5. Procédé selon l'une des revendications qui précèdent, **caractérisé en ce que**, pour former la deuxième métallisation en cuivre, une pâte contenant du cuivre d'une épaisseur de 0,01 à 0,1 mm est appliquée.

6. Procédé suivant l'une des revendications qui précèdent, **caractérisé en ce que** sur une face de la couche de céramique (2) avec application de la feuille en cuivre et du procédé DCB, la première métallisation (3) est d'abord générée, de manière à ce qu'au cours d'une autre étape de procédé, une structuration de la feuille de cuivre formant la première métallisation, ait lieu et que dans une étape de procédé suivante, l'application de la pâte formant la deuxième métallisation en cuivre, le séchage de la pâte appliquée et la cuisson qui s'ensuit aient lieu sous atmosphère d'azote a une température inférieure par rapport au processus DCB.

7. Procédé selon une des revendications qui précèdent, **caractérisé en ce que**, après la réalisation de la deuxième métallisation, un finissage au moins par nettoyage des surfaces et/ou par enlèvement d'oxydes ou de restes de pâte ait lieu par décapage fin ou microdécapage.

8. Procédé selon l'une des revendications qui précèdent, **caractérisé en ce que**, dans une autre étape de procédé, un nickelage de la première et/ou de la deuxième métallisation (3, 4) ait lieu sur les surfaces libres.

9. Procédé selon l'une des revendications qui précèdent, **caractérisé en ce que**, pour la formation de la deuxième métallisation sur la couche de céramique (2) en tant que film mince ou couche mince d'une épaisseur de 0,05 à 0,01 mm, une pâte contenant du molybdène (Mo), du manganèse (Mn) ou du tungstène soit appliquée.

10. Procédé selon l'une des revendications qui précèdent, **caractérisé en ce que**, sur la couche de céramique (2) sous la forme de film fin ou de couche mince, la pâte contenant du molybdène (Mo), du manganèse (Mn), ou du tungstène soit d'abord appliquée, puis séchée et cuite à une température comprise entre 1200 et 1300°C, que dans une étape de procédé suivante, une feuille de cuivre formant la première métallisation soit appliquée sur l'autre face de la couche de céramique avec l'aide de la technique DCB, que la première métallisation soit ensuite structurée et qu'au moins le nickelage ait lieu dans la deuxième métallisation au cours d'une étape de procédé ultérieure, une finition, au moins un décapage fin ou un microdécapage, ayant lieu, par exemple, après la structuration de la feuille de cuivre formant la première couche de métal.

11. Procédé selon l'une des revendications qui précèdent, **caractérisé en ce que** le substrat (1, 1a, 1b) est fabriqué avec une quantité d'autres substrats dans une utilisation multiple (7) avec utilisation d'une plaque en céramique de grand format (2) et que la plaque en céramique dotée de lignes de rupture théoriques (8) soit dotée en grand sur une face de la deuxième métallisation (4) et que sur cette face de la plaque en céramique (2a), la pâte formant la deuxième métallisation soit appliquée en grand et de manière à recouvrir les lignes de rupture théoriques (8).

12. Procédé selon l'une des revendications qui précèdent, **caractérisé en ce que** le substrat (1, 1a, 1b) est relié à la deuxième métallisation (4) par une plaque de base (6) en métal, par exemple par brasage ou déformation.

13. Procédé selon l'une des revendications qui précèdent, **caractérisé en ce que**, pour la fabrication du contact total, la pâte formant la deuxième métallisation (4) est appliquée par une ouverture (11) dans la couche de céramique (2) ainsi que par une ouverture dans la feuille de cuivre formant la première métallisation (3), de manière telle que la pâte recouvre également la feuille de cuivre formant la première métallisation (3) dans un domaine proche de l'ouverture (11, 12) pour le contact total (10a).

14. Procédé selon l'une des caractérisations qui précèdent, **caractérisé en ce que**, pour la fabrication d'au moins un contact total, la feuille de cuivre formant la première métallisation (3) ou la première métallisation (3) dans la zone de l'ouverture (11) de la couche de céramique (2) soit au moins dotée d'une ouverture de désaération (13).
